# EUROPEAN PATENT SPECIFICATION

(11) **EP 0 870 294 B1**
(45) Date of publication and mention of the grant of the patent: **06.09.2000**
(21) Application number: 96944869.5
(22) Date of filing: 20.12.1996
(51) Int. Cl.: G09F 9/33, G09G 3/32

(54) **True color flat panel display LED matrix module with driving circuitry**
Flache Anzeigeeinheit für Echtfarben mit LED Punktmatrix und Ansteuermethode und Ansteuerschaltung für LED Punktmatrix
Module d'affichage plat à matrice à DEL de couleurs vraies avec circuits de commande

(30) Priority: 29.12.1995 US 580771; 10.06.1996 US 658440
(43) Date of publication of application: 14.10.1998
(60) Divisional application: 99203882.8
(73) Proprietor: CREE, INC., Durham, NC 27703 (US)
(72) Inventor: VAN DE VEN, Antony, P., Cary, NC 27513 (US); SWOBODA, Charles, M., Cary, NC 27513 (US)
(74) Representative: Warren, Anthony Robert
(86) International application number: US9620200
(87) International publication number: WO9724706

(56) References cited:
- EP-A- 0 303 741
- EP-A- 0 559 124
- DE-A- 3 837 313
- GB-A- 2 176 042
- US-A- 4 772 886
- US-A- 5 324 962
- US-A- 5 393 993
- OPTOELECTRONICS DEVICES AND TECHNOLOGIES, vol. 7, no. 2, 1 December 1992, pages 221-229, XP000336426 KAZUYUKI KOGA ET AL: "RGB MULTI-COLOR LED DOT-MATRIX UNITS AND THEIR APPLICATION TO LARGE-SIZE FLAT DISPLAYS"
- PATENT ABSTRACTS OF JAPAN vol. 095, no. 002, 31 March 1995 & JP 06 314079 A (TOYODA GOSEI CO LTD), 8 November 1994,
- SOLID STATE TECHNOLOGY, vol. 38, no. 8, August 1995, WASHINGTON US, page 30 XP000523384 "Blue LED produces 500-uW output"
- JAPANESE JOURNAL OF APPLIED PHYSICS, PART 2 (LETTERS), 15 OCT. 1995, JAPAN, vol. 34, no. 10B, ISSN 0021-4922, pages L1332-L1335, XP002040117 NAKAMURA S ET AL: "Superbright green InGaN single-quantum-well-structure light-emitting diodes"

## Description

The present invention relates to a thin full color flat panel display with light emitting diodes.

Electronic displays are those electronic components that can convert electrical signals into visual images in real time that are otherwise suitable for direct interpretation--*i.e.* viewing--by a person. Such displays typically serve as the visual interface between persons and electronic devices such as computers, televisions, various forms of machinery, and numerous other applications.

The use of electronic displays has grown rapidly in recent years driven to some extent by the personal computer revolution, but also by other utilitarian and industrial applications in which such electronic displays have begun to partially or completely replace traditional methods of presenting information such as mechanical gauges, and printed paper.

One of the most familiar types of electronic display is the conventional television in which a cathode ray tube (CRT) produces the image. The nature and operation of cathode ray tubes has been well understood for several decades and will not be otherwise discussed in detail herein, except to highlight the recognition that the nature of a CRT's operation requires it to occupy a three-dimensional area that generally is directly proportional to the size of the CRT's display surface. Thus, in the conventional television set or personal computer, the CRT display tends to have a depth that is the same as, or in some cases greater than, the width and height of its display screen.

Accordingly, the desirability for an electronic display that can use space more efficiently has been well recognized for some time, and has driven the development of a number of various devices that are often referred to collectively as "flat-panel displays." A number of techniques have been attempted, and some are relatively well developed, for flat-panel displays. These include gas discharge, plasma displays, electroluminescence, light emitting diodes (LEDS), cathodoluminescence, and liquid crystal displays (LCDs). To date, flat panel technologies have been generally widely used in certain portable displays and in numerical displays that use fewer (*i.e.* less than several hundred) characters. For example, the typical display on a hand-held calculator can be characterized as a flat-panel display even though it tends to operate in only one color, typically using either LEDs or LCDs.

Light emitting diodes have generally been recognized as likely candidate devices for flat panel displays for a number of reasons. These include their solid state operation, the ability to make them in relatively small sizes (thus potentially increasing resolution), and potentially a relatively low cost of manufacture. To date, however, flat panel displays incorporating LEDs have failed to reach their theoretical potential in the actual marketplace.

LED flat panel displays have lacked success in penetrating the technology and the marketplace for several reasons. One basic reason is the lack of suitable or commercial acceptable LEDs in the three primary colors (red, green and blue), that can be combined to form appropriate true color flat panel images. In that regard, color can be defined for certain purposes as "that aspect of visual sensation enabling a human observer to distinguish differences between two structure-free fields of light having the same size, shape and duration." *McGraw-Hill Encyclopedia of Science and Technology,* 7th Edition, Volume 4, p. 150 (1992). Stated differently, color can be formed and perceived by the propagation of electromagnetic radiation in that portion of the electromagnetic spectrum that is generally referred to as "visible." Typically, if the electromagnetic spectrum is considered to cover wavelengths from the long electrical oscillations (e.g. 10¹⁴ micrometers) to cosmic rays (10⁻⁹ micrometers), the visible portion of the spectrum is considered to fall from about 0.770 micrometers (770 nanometers "nm") to about 0.390 micrometers (390 nm). Accordingly, to emit visible light of even a single color, a light emitting diode must produce radiation with a wavelength of between about 390 and 770 nm. In that regard, the theory and operation of light emitting diodes and related photonic devices in general are set forth in appropriate fashion in Sze, *Physics of Semiconductor Devices,* Second Edition, pp. 681-838 (1981) and will not otherwise be discussed in great detail herein, other than as necessary to describe the invention. A similar but more condensed discussion can be found in Dorf, *The Electrical Engineering Handbook,* pp. 1763-1772 (CRC Press 1983).

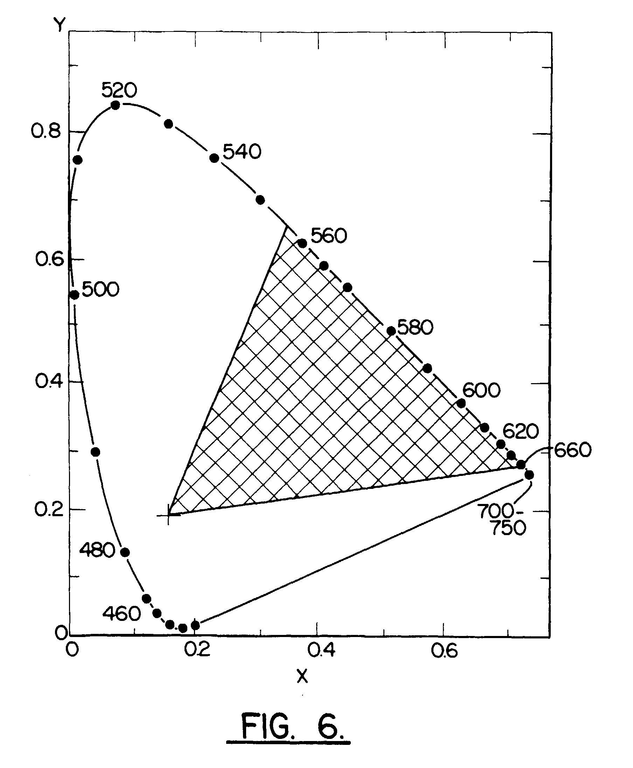

In order for a display of light emitting diodes to form combinations of colors, those diodes must emit primary colors that can be mixed to form other desired colors. A typical method for describing color is the well-recognized "CIE chromaticity diagram" which was developed several decades ago by the International Commission on Illumination (CIE), and a copy of which is reproduced herein as Figure 6. The CIE chromaticity diagram shows the relationship among colors independent of brightness. Generally speaking, the colors visible to the human eye fall on the CIE chart within an area defined by a boundary. As Figure 6 shows, the boundary is made up of a straight line between 380 and 660 nm, and a curved line which forms the remainder of the generally cone-shaped area.

Although the color perceptions of individual persons may of course differ, it is generally well understood and expected that colors visible by most persons fall within the boundaries of the CIE diagram.

Accordingly, the color output of electronic displays, including flat panel displays, can be plotted on the CIE diagram. More particularly, if the wavelengths of the red, green, and blue primary elements of the display are plotted on the CIE diagram, the color combinations that the device can produce are represented by the triangular area taken between the primary wavelengths produced. Thus, in Figure 6, the best available devices are plotted as the lines between the wavelengths of about 655 or 660 nanometers for aluminum gallium arsenide (AlGaAs) red devices, about 560 nanometers for gallium phosphide green devices, and about 480 nanometers for silicon carbide (SiC) blue devices. Gallium phosphide can also be used in red-emitted devices, but these generally emit in the 700 nm range. Because the human eye is less responsive at 700 nm, the devices tend to lack brightness and thus are often limited to applications where maximum brightness is less critical. Similarly, silicon carbide blue devices have only been commercially available for approximately a decade. As the triangle formed by joining these wavelengths on the CIE diagram demonstrates, there exist entire ranges of colors in both the upper and lower portions of the CIE diagram that even these most recently available displays simply cannot produce by the limitations of the physics of their LEDs.

Stated somewhat more simply, although certain LED displays can be described as "full color," they cannot be classified as "true color" unless and until they incorporate LEDs that are respectively more green, more red, and more blue, and that are formed from devices that can have sufficient brightness to make the devices worthwhile. For simplicity's sake, however, the terms "full color" and "true color" are used synonymously hereinafter.

In regard to color and brightness, and as set forth in the reference materials mentioned above, the characteristics of an LED depend primarily on the material from which it is made, including its characteristic as either a direct or indirect emitter. First, as noted above and as generally familiar to those in the electronic arts, because blue light is among the shortest wavelengths of the visible spectrum, it represents the highest energy photon as among the three primary colors. In turn, blue light can only be produced by materials with a bandgap sufficiently wide to permit a transition in electron volts that corresponds to such a higher energy shorter wavelength photon. Such materials are generally limited to silicon carbide, gallium nitride, certain other Group III nitrides, and diamond. For a number of reasons, all of these materials have been historically difficult to work with, generally because of their physical properties, their crystallography, and the difficulty in forming them into both bulk crystals and epitaxial layers, both of which are generally (although not exclusively) structural requirements for light emitting diodes.

As noted above, some SiC blue LEDs--*i.e.* those in which SiC forms the active layer--have become available in commercially meaningful quantities in recent years. Nevertheless, the photon emitted by SiC results from an "indirect" transition rather than a "direct" one (see Sze supra, § 12.2.1 at pages 684-686). The net effect is that SiC LEDs are limited in brightness. Thus, although their recent availability represents a technological and commercial breakthrough, their limited brightness likewise limits some of their applicability to displays, particularly larger displays that are most desirably used in bright conditions; e.g. outdoor displays used in daylight.

Accordingly, more recent work has focused on Group III (Al, In, Ga) nitrides, which have bandgaps sufficient to produce blue light, and which are direct emitters and thus offer even greater brightness potential. Group III nitrides present their own set of problems and challenges. Nevertheless, recent advances have placed Group III nitride devices into the commercial realm, and a number of these are set forth in related patents and copending applications including US-A-5,393,993 and Serial No. 08/309,251 (US-A-5 523 589 published 4,6,96) filed September 20, 1994 for *"Vertical Geometry Light Emitting Diode With Group II Nitride Active Layer and Extended Lifetime";* No. 08/309,247 (US-A-5 592 501 published 7,1,97) filed September 20, 1994 for *"Low Strain Laser Structure With Group III Nitride Active Layers";* and No. 08/436,141 (US-A-5 739 554 published 14,4,98) filed May 8, 1995 for *"Double Heterojunction Light Emitting Diode With Gallium Nitride Active Layer"*.

As another disadvantage, flat panel displays in the current art are generally only "flat" in comparison to CRTs, and in reality have some substantial thickness. For example, a typical "flat" LED display is made up of a plurality of LED lamps. As used herein, the term "lamp" refers to one or more light emitting diodes encased in some optical medium such as a transparent polymer, and with an appropriate size and shape to enhance the perceived output of the LED. In turn, the lamps must be connected to various driving circuits, typically a multiplexing circuit that drives rows and columns in a two-dimensional matrix of such devices. These in turn require appropriate power supplies and related circuitry. The net result are devices that--although thin compared to CRTs--do have significant physical depth.

For example, LED flat panel displays of any size are typically always several inches (1 inch = 2,54 cm) in depth and few if any are produced that are less than an inch (2,5 cm) in depth in actual use. Indeed, some of the largest flat panel displays with which the public might be familiar (i.e. stadium scoreboards and the like) use either enough LEDs or incandescent lamps to require significant heat transfer capabilities. For example, a stadium-size flat display is typically backed by an atmospherically controlled space; i.e. an air conditioned room; to take care of the heat that is generated.

The problems of heat generated by the present LED displays is caused, in part, by the differing operating voltages of the various LEDs utilized to create the red, green and blue elements. For example, in the case of a blue LED formed of gallium nitride, the forward voltage drop across the LED is 7 volts at 70 mA current. However, for a typical green LED at 70 mA current the voltage drop is only 2.8 volts and 2.1 volts for a red LED at 70 mA current. This difference in forward voltage drops has previously present difficulties in driving the LEDs of a true color LED system.

The result of the disparate voltage drops between the red green and blue LEDs is excess heat generation as the differences in voltage are dissipated external to the LEDs. While the excess heat can be dealt with in larger displays of for example 0.3 inch (7.6 mm) pitch or greater by surface dissipation or forced air cooling, as the size of the display is reduced the problem of how to dissipate the excess heat is increased. Despite the decrease in size, the heat generated remains the same but there is less and less surface area to heat dissipation.

The excess heat resulting from the varying forward voltage drops across the LEDs reduces the life of the LEDs and, therefore, over time reduces the LEDs brightness. The brightness of the LEDs is higher at lower operating temperatures. Thus, less heat allows for lower operating currents for the same operational brightness which in turn produces less excess heat. This reduction in current may also improve the color of the LEDs. For example, green LEDs color is improved at lower operating currents. Furthermore, each of the LEDs respond differently as their operating temperatures increase and, therefore, the color characteristics of the display can change over a temperature range. Because of the varying thermal characteristics of the components of a true color display, excess heat can cause stress within the components which can cause mechanical failures including failures in the component connections. In fact, if the heat becomes too excessive it can even deform the plastic components.

Accordingly, the need exists and remains for a flat panel display formed of light emitting diodes that can produce a full range of colors rather than simply multiple colors, and which can do so in a truly thin physical space. Furthermore, the need exists and remains for a system of driving true color displays formed of light emitting diodes that can produce a full range of colors rather than simply multiple colors which reduces the amount of heat generated by the display, improves the color of the display, reduces the amount of power used by the display, increases the brightness of the display and provides longer component life for the display.

Accordingly, it is an object of the present invention to provide a flat panel display that can produce a full range of true colors and that can do so in module form so that large panel displays can be formed of such modules and yet without increasing the overall thickness required for the display.

According to the invention, there is provided a thin full-color flat panel display module that comprises a printed circuit board, a matrix of substantially flat full-range true color pixels mounted to a first surface of the printed circuit board, with each of the pixels comprising a light emitting diode (LED) that emits in the red portion of the visible spectrum, an LED that emits in the green portion of the visible spectrum and an LED that emits in the blue portion of the visible spectrum, combined with driving circuitry for selectively activating the light emitting diodes, with the driving circuitry mounted on the opposite surface of the printed circuit board from the light emitting diodes.

Reference will now be made to the accompanying drawings, which illustrate preferred and exemplary embodiments and wherein:
Figure 1 is a perspective view of a module embodying the present invention;
Figure 2 is a perspective view of the rear portion of the module of Figure 1;
Figure 3 is a circuit diagram illustrating a portion of the driving circuitry of the module embodying the present invention;
Figure 3A is a circuit diagram illustrating a portion of an alternative embodiment of the driving circuitry for the module embodying the present invention;
Figure 4 is a timing diagram that illustrates the operation of the module embodying the present invention;
Figure 4A is a timing diagram that illustrates the operation of an alternative embodiment of the present invention;
Figure 5 is a schematic diagram of a pixel incorporated in a module embodying the present invention;
Figure 6 is a CIE curve illustrating a portion of those visible colors typically produced by prior art multicolor devices;
Figure 7 is a CIE chart which shows the additional colors that can be produced by the pixels and modules embodying the present invention;
Figure 8 is a schematic diagram of the arrangement of pixels on the printed circuit board;
Figure 9 is a flow diagram of one aspect of the manner in which the module embodying the invention displays data;
Figure 10 is a flow diagram showing the manner in which a microprocessor controller can produce a display using a module embodying the present invention;
Figure 11 is another flow diagram showing the manner in which various image information can be transmitted to the module embodying the present invention; and
Figure 12 is a schematic diagram of a driver circuit embodying the present invention.

The thin flat panel display module embodying the invention is capable of producing a full range of true colors. As set forth above, the term true color refers to a much greater range of colors than have been previously available from prior devices incorporating either light emitting diode or other technologies. The thin flat panel display module is suitable as a subassembly for construction of any size, although predominantly wall sized, thin flat panel displays. The modules embodying the invention are capable of displaying portions of any visual image, either moving or stationary, in either any color or combination of colors. By combining modules horizontally and vertically, virtually any size of display board can be constructed.

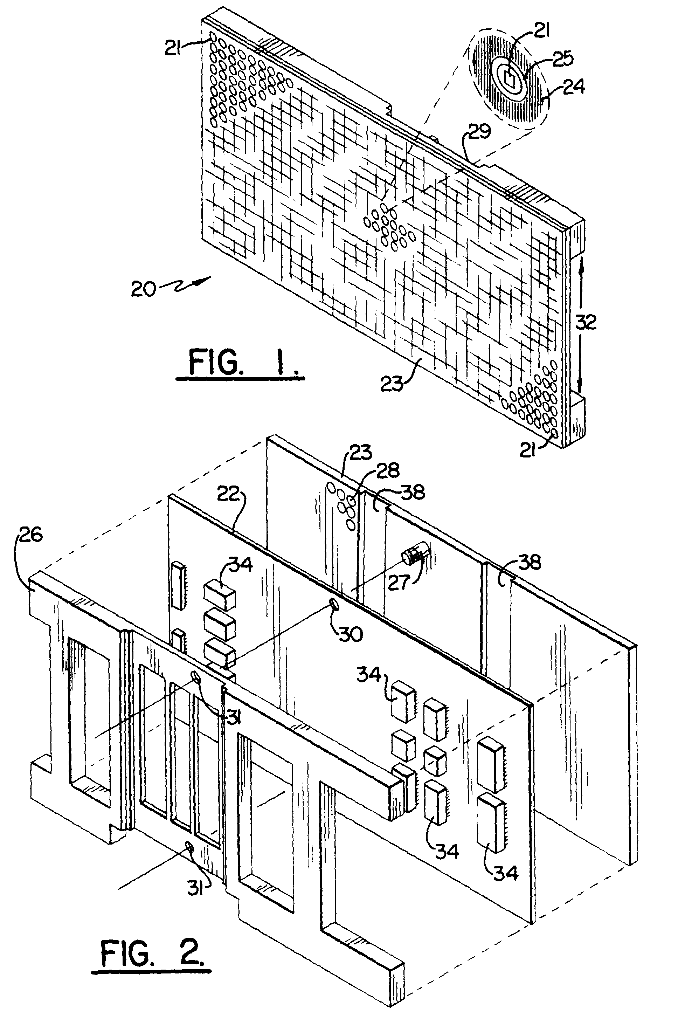

Figures 1 and 2 are front and rear perspective views showing the module broadly designated at 20. A matrix of substantially flat full color pixels, several of which are labeled as 21 in Figure 1 are mounted on a first surface of a printed circuit board 22. As will be set forth in more detail herein, each of the pixels 21 comprises a red LED, a green LED and a blue LED. As perhaps best illustrated in Figure 2, the driving circuitry for the light emitting diode pixels is mounted on the opposite surface of the printed circuit board 22.

It will also be understood that a pixel could include more than one LED of one or more of the colors as might be desired for certain applications of the pixels and the modules. For the sake of brevity, however, the pixels herein will be described in terms of one red, one green, and one blue LED.

Figure 1 further illustrates that the module **20** also comprises a front masking plate **23** on the same surface of the printed circuit board as the pixels **21.** As further illustrated in the enlarged portion of Figure 1, the front masking plate can comprise contrast enhancement means which in the illustrated embodiment comprises the dark portions **24** of the masking plate **23** and the white reflector portions **25.** Whenever an individual pixel **21** is lighted, the contrast between the dark portion **24** and the white portion **25** combined with the output of the pixel can help enhance the overall image to persons viewing it.

In preferred embodiments the front masking plate **23** comprises a molded plastic panel, typically a plastic such as acrylonitrile butadiene styrene copolymer (ABS), with a matrix of holes **28** dissecting the front and back of the panel so that the holes are arranged in a matrix of the same or substantially similar position and size as the pixels **21** mounted on the printed circuit board **22.** In the preferred embodiments, the walls of the holes **28** are at an angle to thereby provide a means of reflecting light emitted obliquely from the pixels **21** forward from the module and the size of the holes at the front of the display are of a sufficient diameter, relative to the pitch of the holes, to provide a suitably high density and a pleasant visual image, while leaving sufficient area surrounding each of the holes to provide a contrast ratio.

The preferred embodiment uses a ratio of hole to pixel pitch of not less than 5.5 to 7.62. As noted above, the inside surfaces **25** of the holes are either white or some similar reflective color, while the area **24** surrounding the holes is of a dark or contrasting color.

Figure 2 shows that the display module **20** can further comprise a supporting frame **26** on the opposite surface of the printed circuit board from the pixels **21**. In preferred embodiments, the front masking plate further comprises a post **27.** The printed circuit board **22** comprises a clearance hole **30** that can be aligned with the post **27**, and through which the post **27** extends. The supporting frame **26** includes means, shown as the holes **31**, for receiving the posts **27** and into which the posts **27** are received, as well as means, such as a threaded interior (not shown) of the post **27,** which when combined with a screw or bolt secures the frame **26** to the post **27.** These features secure the front masking plate **23** to the supporting frame **26** with the printed circuit board **22** therebetween and thereby minimize or prevent dislocation between the printed circuit board **22** and the masking plate **23** or the frame **26,** but while allowing the printed circuit board and the frame **26** to move independently enough to avoid damage in the case of thermal expansion.

As Figure 2 illustrates, in preferred embodiments the frame **26** defines a first slot **32** adjacent the printed circuit board **22** for permitting the flow of air between the frame **26** and the printed circuit board **22** to aid in the dissipation of heat. In a further aspect of the preferred embodiment, the frame **26** also comprises a conductive mounting means opposite the printed circuit board **22** for removably clipping the module to a power source. The mounting means preferably comprises a second slot **29** opposite the printed circuit board from the pixels that can be connected to a standard power source such as a bus bar.

In preferred embodiments, the front masking plate **23** can also comprise several slots **38** for air flow, and can further comprise a conductive coating, typically a spray painted conductive coating, that is in contact with the ground signal of the driving circuitry to thereby reduce the electromagnetic emissions of the module **20.**

The module **20** of the present invention also comprises driving circuitry shown as the circuit elements in Figure 2, several of which are designated at **34.** The circuit elements **34** are interconnected with the pixels **21** through the printed circuit board **22**. By mounting the driving circuitry on the same printed circuit board as the pixels, the invention provides an extremely narrow profile for the module regardless of the overall size of a single module (*i.e.* rows and columns), and regardless of how many modules are combined to form a total display.

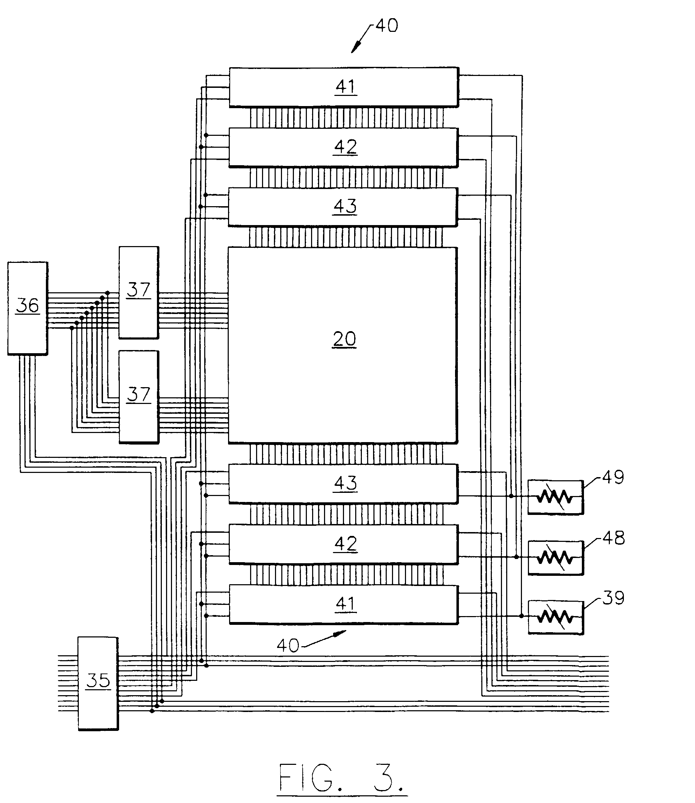

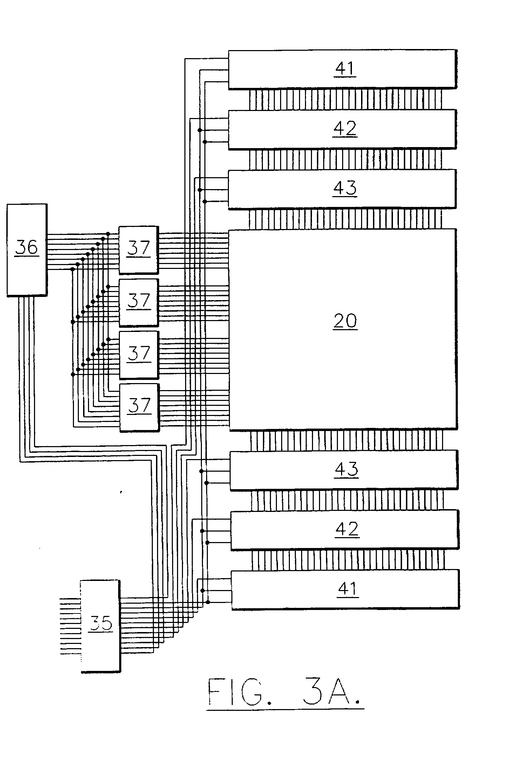

Figure 3 illustrates some of the specified circuit elements of the present invention. Preferably the driving circuitry comprises an input buffer **35,** demultiplexer **36** electrically responsive to the input buffer **35,** a row driver **37** electrically responsive to the demultiplexer **36,** and a column driver broadly designated at **40** electrically responsive to the input buffer. It will be understood, however, that a number of circuits exist, or can be designed, to drive electronic displays. See, e.g. Chapter 77 of Dorf, The Electrical Engineering Handbook (CRC Press, 1993) pages 1763ff.

Likewise, Figure 3A illustrates a preferred driving circuitry which includes an input buffer **35**, demultiplexer **36** electrically responsive to the input buffer **35,** row drivers **37** electrically responsive to the demultiplexer **36**, and column drivers designated as **41, 42** and **43** electrically responsive to the input buffer.

In the embodiment illustrated in Figure 3, the matrix comprises n rows and 2n columns where n is a power of 2 and wherein the row driver comprises two drivers each of which drive n/2 (i.e. half of) of the rows. Two such drivers **37** are shown in Figure 3 in which each module has 16 rows and 32 columns in the matrix. Accordingly, in the embodiment illustrated in Figure 3, n is 16, 2n is 32, and n/2 is 8, so that each of the drivers (preferably field effect transistors, "FETs") drives eight rows.

In the embodiment illustrated in Figure 3A, the matrix comprises n rows and 2n columns where n is a power of 2 and wherein the row driver comprises four drivers each of which drive n/4 (i.e. one fourth of) of the rows. Four such drivers **37** are shown in Figure 3A. Alternatively, a single row driver capable of driving the number of rows in a group may be utilized. For example, as illustrated in Figure 3A, the matrix is divided into four sets of four row blocks.
Accordingly, a single row driver having the capability of driving four rows may be utilized for all of the four row blocks. The number of blocks is determined by the number of sets of column drivers. As will be appreciated by those of skill in the art, other groupings of column drivers and row drivers may be utilized while still benefitting from the teachings of the present invention.

Figure 3 illustrates that in one embodiment the driving circuitry includes two sets of column drivers **40** each of which represents a respective 32 bit shift register, latch, and driver for the blue data **41** (*i.e.* data to drive the blue LEDs), the green data **42,** and the red data **43.** Three respective potentiometers **39** (blue), **48** (green) and **49** (red) control the current to the individual colors as a whole. The potentiometers can be controlled manually or digitally as may be desired or necessary.

Figure 3A also illustrates that, in an alternative embodiment, the driving circuitry includes four sets of column drivers **41, 42** and **43** each of which represents a respective 32 bit shift register, latch, and driver for the blue data **43** (*i.e.* data to drive the blue LEDs), the green data **42,** and the red data **41.** Only two of the four sets of column drivers are illustrated in Figure 3A, however, the four column drivers are identical except for the rows of the matrix from which the columns are formed and the data which is supplied to the column drivers. Thus, in the embodiment illustrated in Figure 3A the column drivers divide the matrix into four blocks corresponding to 4 rows with 32 columns of red LEDs, 32 columns of green LEDs and 32 columns of blue LEDs. The rows of the blocks correspond to the four sets of row drivers **37.**

Accordingly, the preferred embodiment is a **32** x 16 dot matrix LED flat panel display module which is capable of displaying approximately 16.7 million colors by combining red (660 nm), green (525 nm), and blue (430 nm) LEDs by mixing and pulse width modulation. By combining modules either horizontally, vertically, or both, virtually any size display board can be constructed. The module contains combination shift register, latch and constant current driver integrated circuits and row drive field effect transistors (FETs). The module may use a quad four row multiplexed drive method or dual 8 row multiplexed drive method with 1/8 duty cycle for maximum brightness and minimum clock speeds.

Data is displayed on the module using multiplexing to the display. The individual pixels are arranged in a grid matrix with the common anode of the individual LEDs connected together in horizontal rows and the different color cathodes of the LEDs connected together in columns. In the system of Figure 3, each row (two banks of eight) is connected to a p-type MOSFET current source and each column (three columns per LED column for a total of 96) is connected to a constant current sink driver and associated shift register. For the system illustrated in Figure 3A, each row (four banks of four total) is connected to two p-type MOSFET current sources, one source being at 7.5 volts and a second source at 4.5 volts and each column (three columns per LED column for a total of 96) is connected to a constant current sink driver and an associated shift register. On start up, in either system all row driver FETs are turned off. While the present invention is described with respect to p-type field effect transistors and positive voltages, as will be appreciated by those of skill in the art, other switching devices may be utilized as well as other voltages depending upon the characteristics of the diodes utilized and whether the diodes in a row have commonly connected anodes or cathodes.

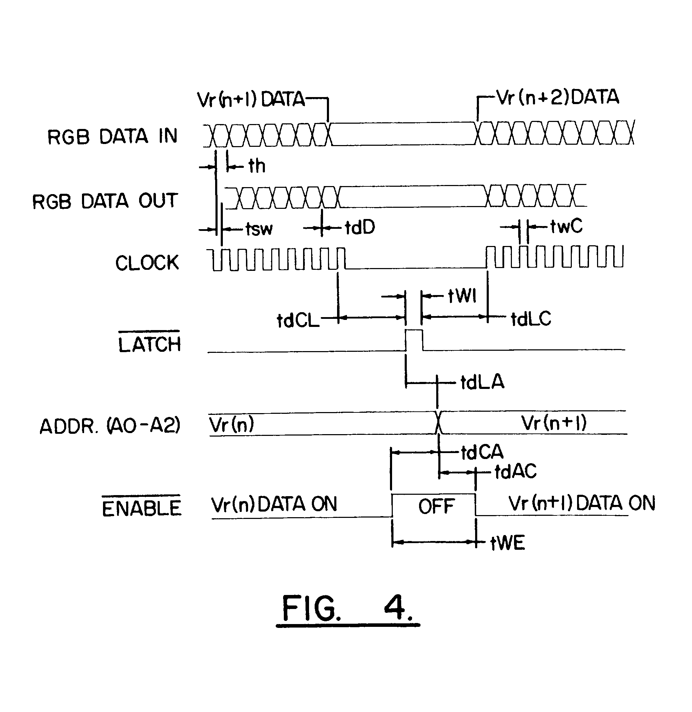

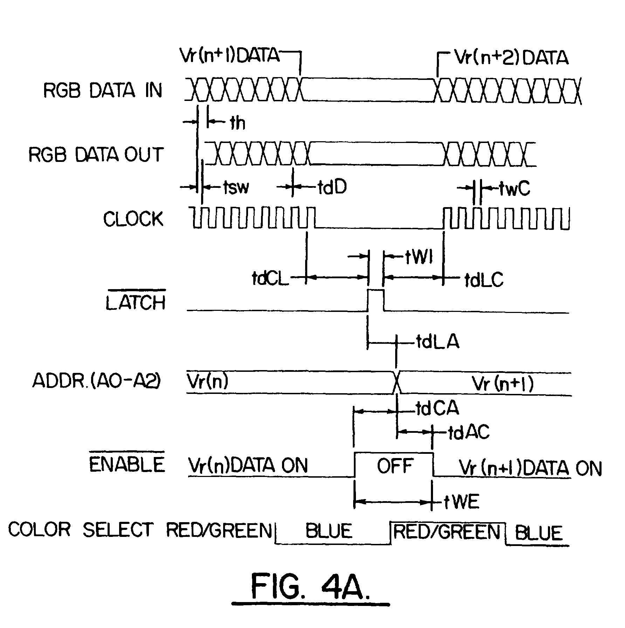

Figure 4 schematically illustrates the following steps associated with the system of Figure 3 that are then applied to each row consecutively commencing with the top row in a continuous repeating cycle to display a visually solid image; the number of RGB datagroups (6 bits wide) relating to a two row of lamps to be displayed next is clocked out into the six shift register banks (*i.e.* one bank for red, one for green and one for blue for the top eight rows and another three for the bottom eight rows) on the rising edge of the clock signal. The number of data groups shifted out should be equal to the number of columns in the display, and is 32 clock cycles in the case of the preferred embodiment. Data to be displayed on the side of the modules farthest (electronically) from the input buffer is output first. The row driver FETs are then turned off by taking the "enable" signal high. The data in the shift registers is then latched into the column drivers by pulsing the "latch" signal low for no less than 25 nanoseconds (ns). The row address to the data shifted out is then placed on the A0-A2 signals (address 0 being the top row (row 8) and seven being the bottom row (row 7) also). This value is normally incremented 0,1,...7 etc. (from top to bottom for each half of the display). The row driver FET is then enabled by taking the enable signal low. The rows of LEDs will now show the image for that row. The process is then repeated for each row in a cyclical manner accessing all rows approximately 60 times per second to display a flicker-free multiplexed visually solid image.

Figure 4A schematically illustrates the following steps associated with the system of Figure 3A that are then applied to each row consecutively commencing with the top row in a continuous repeating cycle to display a visually solid image; the number of RGB data groups (3 bits wide with a total of 12 bits for all four blocks) relating to the rows of lamps to be displayed next is clocked out into the 12 shift register banks *(i.e.* one bank for red, one for green and one for blue for each block corresponding to the four row drivers) on the rising edge of the clock signal. The number of data groups shifted out should be equal to the number of columns in the display, and is 32 clock cycles in the case of the preferred embodiment. Data to be displayed on the side of the modules farthest (electronically) from the input buffer is output first. The row driver FETs are then turned off by taking the complement of the "enable" signal high. The data in the shift registers is then latched into the column drivers by pulsing the "latch" signal low for no less than 25 nanoseconds (ns). The row address to the data shifted out is then placed on the A0-A1 signals (address 0 being the top row (row 0) and address 3 being the bottom row (row 3) of each block of rows). This value is normally incremented 0,1,2,3 etc. (from top to bottom for each quarter of the display). The row driver FETs are then enabled by taking the enable signal low. For each address, the "Color select" signal changes state from low to high once for each data cycle while the Enable signal is active. This "Color Select" signal switches the drivers from the first voltage to the second voltage of the LEDs such that when the Color Select selects the blue LED shift registers the drivers supply 7.5 volts to the row and when the Color Select signal selects the red and green shift registers the row drivers supply 4.5 volts to the row. This multiplexes the time per refresh cycle which the blue and the red and green LEDs are active while maintaining the overall refresh rate for the system. This assures the refresh rate of the rows will remain 1 to 8. The rows of LEDs will show the image for that row. The process is then repeated for each row in a cyclical manner accessing all rows generally greater than 60 times per second and preferably about 1000 times per second to display a flicker-free multiplexed visually solid image.

Further to the preferred embodiments of the invention, each pixel **21** comprises a common anode for all three of its LEDs for turning the entire pixel on or off, and an individual cathode for each individual LED in the pixel for controlling the state and brightness of each LED, to thereby control the overall color emitted by the pixel. The level of current through the LED may be controlled by a resistor placed in series with the LED. This resistor may be variable.

In preferred embodiments, the invention further comprises a monostable circuit means for preventing the maximum rating of the diodes in the pixels from being exceeded. More specifically, on the rising edge of the enable signal the output goes high or stays high for a time period set by a capacitor and resistor in series. The capacitor and resistor are adjusted such that the length of time the output stays high is longer than the time between successive enable transitions. Therefore if the enable transition does not occur due to controller failure, then the output signal goes low disabling the column driver **4** and turning off the LEDs.

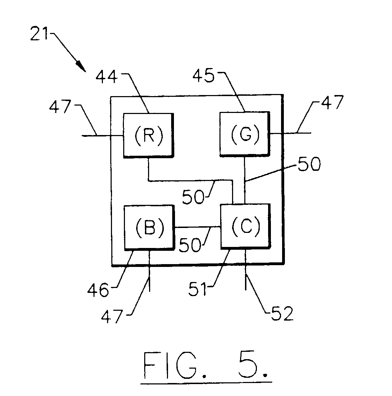

As set forth in the background portion of the specification, one of the problems solved by modules embodying the invention and the advantages it offers are the wide range of colors available from the LEDs which are incorporated into the pixels and thus into the matrix and the modules. Figure 5 illustrates such a pixel schematically and broadly designated at **21** consistent with the earlier numbering. The pixel includes an LED **44** that emits in the red portion of the visible spectrum, an LED **45** that emits in the green portion of the visible spectrum, and an LED **46** that emits in the blue region of the visible spectrum. The red, green and blue LEDs **44, 45,** and **46** are adjacent one another and have their respective top contacts in substantially the same plane on the pixel. The red LED **44** includes at least one active layer of aluminum gallium arsenide (AlGaAs), and the red LED **44** also has its respective top anode contact in substantially the same plane as the anode contacts of the blue LED **46** and the green LED **45.**

Similarly, the back contacts of all of the LED's can likewise be placed in a common plane (preferably different from the plane of the top contacts).

It will be immediately understood by those familiar with this subject matter that the ability to place all of the top contacts in substantially the same plane, and all of the bottom contacts in their own common plane, greatly enhances the operability of the pixels, and thus of the matrix and the entire module.

As further shown in Figure 5, each diode has a respective diode cathode contact **47** and an anode contact **50.** The anode contacts **50,** however, are attached to a common anode pad **51** which in turn is connected to a common anode contact **52.** This arrangement allows for the individual control described above.

In preferred embodiments, the blue LED **46** comprises a silicon carbide substrate and a Group III active nitride layer, with gallium nitride being a particularly preferred active layer. Such light emitting diodes are well described in the earlier-noted incorporated patent and copending applications.

As noted above, the red LED is preferably formed of aluminum gallium arsenide.

The green LED **45** can be formed of a Group III phosphide active layer such as gallium phosphide or aluminum indium gallium phosphide, or the green LED can be formed similar to the blue LED in that it comprises a silicon carbide substrate and a gallium nitride active layer.

In embodiments in which both the blue and green LED comprise silicon carbide substrates and Group III active layers, their voltage parameters can be generally matched to one another to simplify the driving circuitry.

In preferred embodiments, the LEDs are all driven by constant current devices, these drive sources, however, selectively provide differing voltages to the LEDS to compensate for the differences between the forward voltage characteristics of the red LED, the green LED and the blue LED.

Alternatively, the LEDs may be all driven by constant current devices, but with a resistor in series in the circuit between the constant current drive means and the cathode of the red LED **44** to compensate for the differences between the forward voltage characteristics of the red LED in aluminum gallium arsenide and the forward voltage characteristics of the matched blue and green LEDs in silicon carbide and gallium nitride.

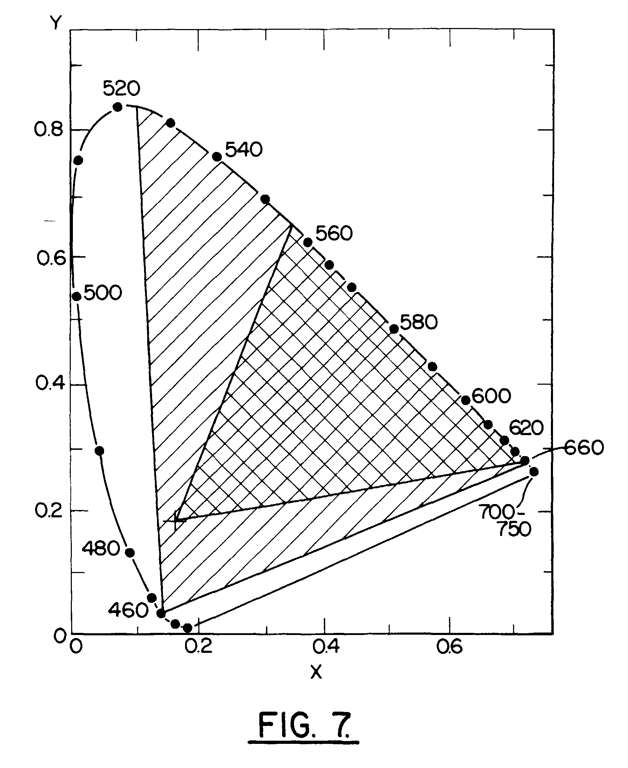

Because of the types of light emitting diodes that are incorporated in the modules embodying the present invention, and which were previously unavailable for such use, the pixels may be formed of solid state light emitting diodes that can form any color on that portion of a CIE curve that falls within the triangle whose sides are formed by a line on the CIE curve between 430 nm and 660 nm, a line between 660 nm and points between 500 and 530 nm. Such a CIE curve and triangle are illustrated in Figure 7. Stated differently, because the output of the LEDs incorporated in the pixels of the present invention are essentially farther apart from one another on the CIE curve, the range of colors that can be produced by the pixels, and thus by the modules, is much greater than that previously available. Indeed, the modules embodying the present invention essentially provide true color display capabilities, while previous devices have only been able to produce multicolor displays.

It will be understood, of course, that the area on the CIE curve that represents the colors produced by the invention is exemplary rather than absolute or otherwise limiting of the invention. For example, Figure 7 illustrates the "green" corner of the color triangle as falling at about 525 nm. As noted elsewhere, herein, however, the green corner could fall from 500 to 530 nm depending on the particular diode. In such cases, the triangle defined on the CIE curve would have a slightly different appearance than Figure 7, but one that could be easily superimposed on the CIE curve once the precise outputs of the LED's were identified.

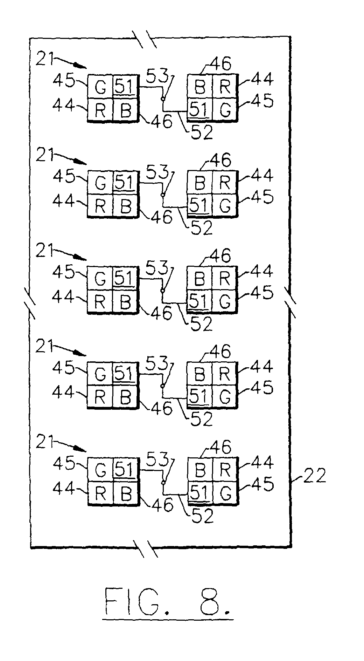

The modules embodying the invention may incorporate a novel arrangement of the pixels on the printed circuit board. In this embodiment, the display module comprises a matrix of LED pixels arranged in horizontal rows and vertical rows (columns) on a printed circuit board, a portion of which is schematically illustrated in Figure 8. Figure 8 incorporates the same numbering scheme as the previous illustrations such that the printed circuit board is designated at **22** and the individual pixels at **21**. Similarly, the red, green and blue LEDs are designated at **44, 45** and **46** respectively within each pixel. Figure 8 also shows several via holes **53.**

Figure 8 further illustrates portions of five rows and two columns on the printed circuit board **22.** As previously described with respect to Figure 5, each pixel comprises four respective quadrants that are essentially defined by the positions of the red, green and blue LEDs (44, 45, 46) and the common contact pad **51** in the fourth quadrant. Figure 8 illustrates that the LEDs have the same quadrant relationship to each other within each pixel, and that the quadrants are oriented identically in the pixels in each column. Thus, Figure 8 illustrates that in the left hand column, the red LED **44** occupies the lower left quadrant, the green LED **45** the upper left quadrant, the blue LED **46** the lower right quadrant, and the common contact pad **51** the upper right quadrant.

In order to minimize the via holes **53** required, however, the invention advantageously rotates the orientation of alternating columns of LEDs so that the pixels in any given column are oriented either 90° or 180° opposite the pixels in the adjacent column. Thus, in the right hand column illustrated in Figure 8, the common contact pad **51** is in the lower left quadrant, the blue LED **46** is in the upper left quadrant, the green LED **45** is in the lower right quadrant, and the red LED **44** is in the upper right quadrant. As Figure 8 illustrates, this positions both the common contact pads **51** in the left hand column and the common contact pads **51** in the right hand column adjacent one another so that a single via hole can accommodate the lead from two LEDs can be substantially reduced. Thus, Figure 8 illustrates that the printed circuit board **22** has one common anode via hole **53** for each two pixels with each common via hole **53** being positioned between the two adjacent columns of pixels and between the respective common anode pads **51** of the respective pixels **21** in each of the adjacent columns so that an anode lead **52** from each of the two pixels can pass through the common via hole **53** thus minimizing the total number of via holes, and the complexity of the remaining circuitry and of its manufacture and other factors, required in the printed circuit board **22**.

As noted above, the common contact pad **51** preferably comprises the anode pad. The pixels **21** in this arrangement are on the module **20** in a matrix (as noted previously the preferred embodiment is two blocks of eight horizontal rows and 32 vertical columns) with the electrical connections between the common anodes for all pixels in the same horizontal row to an associated row driver and interconnections between cathodes of the same colored diodes in the vertical columns within the same block to associated constant current sink drivers. The pixels **21** are therefore provided with four controls means: the anode connection controlling whether the lamp as a complete unit is on or off and the three cathode connections controlling the state and brightness of the individual colored diodes with the lamp and therefore controlling the emitted color of the lamp.

It will be understood, of course, that the same alignment concept can be used between horizontal rows rather than columns, depending upon whether columns or rows are to be multiplexed. Similarly, although Figure 8 illustrates the pixels in the right hand column as having been rotated 180° from those in the left hand column, a rotation of 90° counterclockwise will produce a similarly adjacent relationship between the contact pads in each column. In the illustrated embodiment, the horizontal rows are multiplexed (as described below) so that alternating the pixel orientation on a column-by-column basis is most convenient. If desired, the module could be multiplexed vertically (i.e. by column) and the pixel orientation could be rotated on an alternating row basis. Thus, Figure 8 and the multiplexing description that follows herein illustrate a preferred embodiment of the invention rather than limiting it.

The preferred embodiment uses a version of the technique known in the art as multiplex scanning wherein each row or column in the matrix is individually illuminated in a continuous succession at a sufficiently high repetition rate to form an apparently continuous visual image. Customarily such modules utilize a multiplex ratio equal to the height of the display in rows. In the case of multiple rows of modules forming the display, the rows of each module are controlled in parallel. Such means provides a low cost method of controlling a large number of pixels as only one set of column drivers is required for a large number of rows of pixels. Such arrangements can also be constructed orthorhombically such that only one set of row drivers is required or a large number of columns of pixels.

The lamps are provided with power generally equal to the number of rows multiplied by the continuous current rating of the individual diodes. Therefore, when the individual diodes have a nominal d.c. current rating of 20 milliamps (mA) and the multiplex is sixteen, up to 320 mA of current is applied. This high current stresses the diode, however, and shortens its life. Additionally, some diode materials saturate at much lower currents. Furthermore, it is generally recognized that 100 mA is the ideal maximum current to maintain lamp life.

A further problem with multiplexing 16 rows is that 16 separate refreshes are required within the cycle time. This results in higher shift clock speeds, and leads to the use of expensive buffers, and require extensive filtering to reduce electromagnetic emissions. Accordingly, the feature of the preferred embodiment of the invention in which the rows are split into blocks of not more than four rows per block allows more brightness per pixel (*i.e.* 100 mA/8 versus 100 mA/16), lower clock update speeds, and less heat emitted from the column drivers. This splitting can, of course, be applied to modules having any number of rows greater than four.

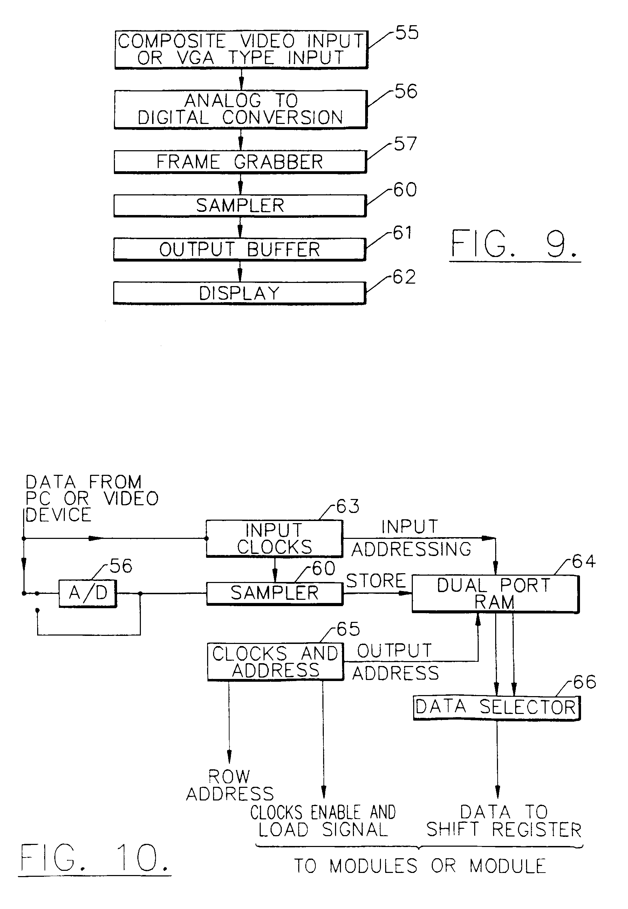

Figures 9, 10 and 11 further illustrate the operation of preferred embodiments of the invention. Figure 9 is a flow diagram that shows that an image to be displayed can originate as a composite video input or as a VGA-type input. If it is a composition video input, the signal is converted from analog to digital by the analog to digital converter designated at **56**. The input from either the converter **56** or the VGA input **55** then is sent to the frame grabber **57** then to the sampler **60.** The frame grabber **57** synchronizes to the horizontal or vertical sync signals present at the beginning of each frame and line of a video signal.

After detecting the sync signal the digital data is stored in memory **64** with the sync signal providing a known reference so that the data can be stored in a repeatable and organized method.

Alternative frames are usually stored in alternative frame buffer areas **61** allowing the sampler **60** to read the previously grabbed frame while the frame grabber **57** stores the current frame. The signal then proceeds to the modules of the invention which form the display **62.**

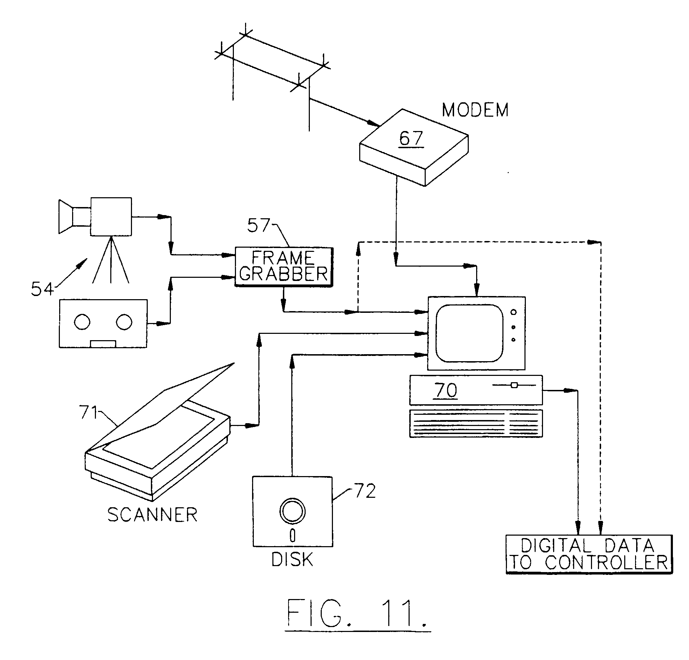

Figure 10 illustrates how a microprocessor controller is used to run each of the modules. The data from the desired source proceeds to the input clock **63** which can send the data either to the sampler **60** or to random access memory ("RAM") **64.** Figure 10 again illustrates that where necessary a signal can be sent to an analog to digital converter **56.** The data can then be sent from RAM to the clocks and the addressing system **65**, or to the data selector **66.** The clocks and address selectors send the signals to the rows and columns as desired, while the data selector sends it to a shift register in the modules as previously described.

Figure 11 illustrates that a display can be produced from a number of sources including information available by telecommunication lines (illustrated by the modem **67**), the video input previously designated at **54** and illustrated in Figure 10 as either a camera or a magnetic memory such as a video tape through the frame grabber **57** to the microprocessor (e.g. personal computer) **70**. The information can also come from a scanner **71** or from electromagnetic memory such as the disk (or any equivalent device) **72**. The microprocessor in the personal computer **70** operates in accordance with the scheme described with respect to Figures 9 and 10, and produces the information for the modules to display.

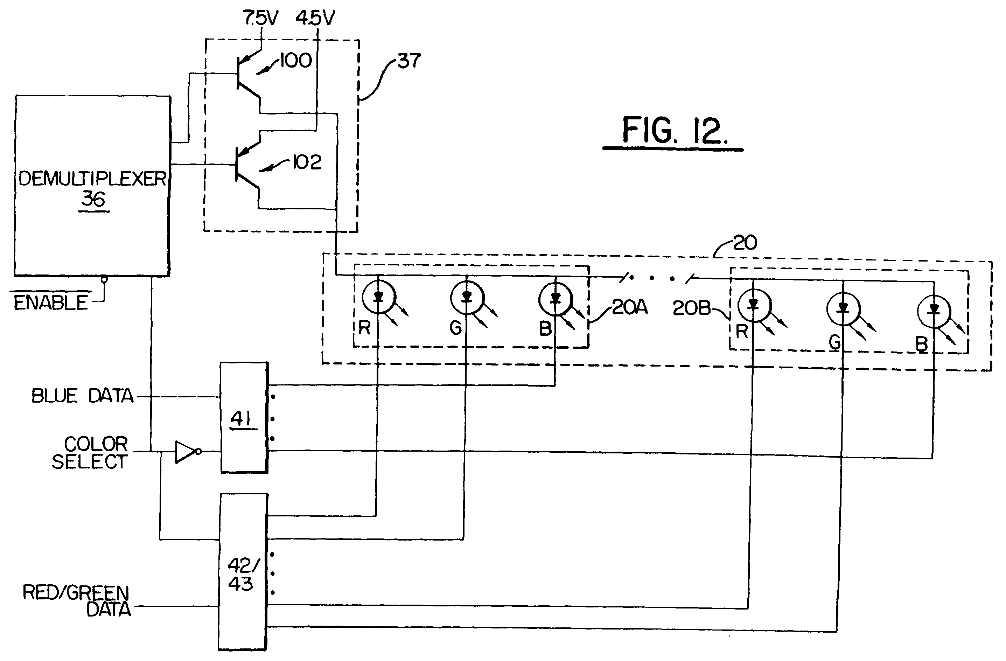

A further illustration of the embodiment of the present invention is illustrated in Figure 12. As seen in Figure 12, a portion of the matrix **20** is illustrated. This portion of the matrix **20** shows a row of LEDs, with each lamp **20A** and **20B** in the row having a red, green and blue LED. While two lamps are illustrated, as described above, the row may contain varying numbers of lamps. The demultiplexer **36** and two transistor drivers **100** and **102** of the row drivers **37** are illustrated. Also illustrated are the column drivers **41, 42** and **43** with drivers **42** and **43** illustrated as a single block.

As seen in Figure 12, drive transistor **100** is connected to a 7.5 volt voltage source and drive transistor **102** is connected to a 4.5 volt voltage source. The outputs of transistors **100** and **102** are connected together and connected to the LED row of matrix **20.** In operation, as described above, the shift registers of column drivers **41, 42** and **43** are loaded with data for a row of the matrix. The Enable signal then goes low to activate the row drivers. Based on the state of the Color Select signal, the demultiplexer **36** activates either transistor **100** or transistor **102.** As illustrated in Figure 12, when the Color Select signal is high such that the Red/Green column drivers **42** and **43** are enabled, the demultiplexer **36** selects transistor **102** and 4.5 volts is applied to the anodes of the diodes in the row of the matrix. When the Color Select signal goes low such that the blue drivers **41** is enabled, the demultiplexer **36** selects transistor **100** and 7.5 volts is applied to the anodes of the diodes in the row of the matrix. Thus, different voltages are applied to different color LEDs in the matrix **20.** The voltages are multiplexed to the row based on the Color Select signal. This is accomplished by transistor **100** providing a first voltage to blue LEDs in the matrix of LEDs and transistor **102** providing a second voltage to red and green LEDs in the matrix of LEDs.

While the present invention has been described with respect to two voltages and with red and green LEDs grouped together, as will be appreciated by one of skill in the art, more than two voltages may be multiplexed to the LED matrix. For example, a separate voltage could be provided for each color LED in the matrix. Alternatively, a separate voltage could be provided for each group of LEDs which have common operating characteristics. Likewise, other groupings of colors of LEDs could be utilized. These alternative embodiments would need to have a driver for each voltage desired and a signal which selects the desired voltage at the appropriate time.

In addition to simply selecting between the voltage to apply to the LEDs, the duty cycle of the signal which selects the activation of the LEDs may be varied so as to illuminate different color LEDs for different times during each scan cycle. This varying duty cycle may be utilized, for example, to balance color between the LEDs.

Although the invention has been described with respect to individual pixels, and single modules, it will be understood that one of the particularly advantageous aspects of the invention is the capability for any number of modules to be connected with one another and driven in any appropriate manner to form large screen displays of almost any size. As is well understood to those in this art, the size of the pixels and the modules can be varied depending upon the desired point source of light. In this regard, it is well understood that a plurality of light sources of a particular size will be perceived as a single point source by an observer once that observer moves a certain distance away from those multiple sources. Accordingly, for smaller displays such as televisions, the individual pixels are maintained relatively small so that an observer can sit relatively close to the display and still perceive the picture as being formed of point sources. Alternatively, for a larger display such as outdoor displays, signage and scoreboards, the observer typically views the display at a greater distance. Thus, larger pixels, larger modules and the like can be incorporated to give brighter light while still providing the optics of point sources to the more distant observers.

## Claims

1. A thin full color flat panel display module (**20**), comprising:
a printed circuit board (**22**);
a matrix of substantially flat full color pixels (**21**) mounted to a first surface of said printed circuit board;
each said pixel comprising a light emitting diode (**44**) that emits in the red portion of the visible spectrum, a light emitting diode (**45**) that emits in the green portion of the visible spectrum, and a light emitting diode (**46**) that emits in the blue portion of the visible spectrum; and
driving circuitry (**34**) for selectively activating said light emitting diodes mounted on the opposite surface of said printed circuit board.

2. A module according to Claim 1 further wherein said driving circuitry comprises interconnections between said pixels and said driving circuitry plated through said printed circuit board.

3. A module according to Claim 2 wherein said driving circuitry comprises:
an input buffer (**35**) ;
a demultiplexer (**36**) responsive to said input buffer;
a row driver (**37**) responsive to said demultiplexer; and
a column driver (**40**) responsive to said input buffer.

4. A module according to Claim 1 wherein each said pixel comprises:
a common anode (**51**) for all three LEDs in said pixel for turning the entire pixel on or off; and
an individual cathode (**47**) for each individual LED in said pixel for controlling the state and brightness of each said LED to thereby control the overall color emitted by said pixel.

5. A module according to Claim 1 further comprising a monostable circuit means for detecting the assertion of one or more periodic input signals, and for disabling the power to the pixel when such input signals are absent for a defined period of time so that a maximum rating of said diodes in said pixels is not exceeded.

6. A module according to Claim 1 and further comprising a front masking plate (**23**) on the same surface of said printed circuit board as said pixels.

7. A module according to Claim 6 wherein said front masking plate further comprises lenses over said pixels, and reflectors (**25**) and contrast enhancement means (**24**) adjacent said pixels.

8. A module according to Claim 6 wherein said front masking plate further comprises a conductive coating that is in contact with the ground signal of said driving circuitry to thereby reduce the electromagnetic emissions of said module.

9. A module according to Claim 6 and further comprising a supporting frame (**26**) on said opposite surface of said printed circuit board from said pixels.

10. A module according to Claim 9 wherein:
said front masking plate further comprises a post (**27**) ;
said printed circuit board comprises a clearance hole (**30**) that matches said post and through which said post extends; and
said supporting frame comprises means for receiving said post (**31**) and into which said post is received; and
means for securing said frame to said post to secure said front masking plate to said frame with said printed circuit board therebetween and to thereby minimize or prevent said printed circuit board from dislocation from said plate or said frame, but while allowing said printed circuit board and said frame to move independently in the case of thermal expansion.

11. A module according to claim 9, wherein said frame comprises a first slot (32) adjacent said printed circuit board for permitting the flow of air between said frame and said board to aid in the dissipation of heat.

12. A module according to claim 9, wherein said frame comprises conductive mounting means opposite said printed circuit board for removably clipping said module to a power source.

13. A module according to claim 1, that can form any color on that portion of a CIE curve that falls within a triangle whose sides are formed by a line on the CIE curve between about 430 nm and 660 nm, a line between 660 nm and a point between 500 and 530 nm, and a line between said 500-530 nm point and about 430 nm.

14. A module according to claim 1, wherein said red, green and blue LEDs (44, 45, 46) of each pixel are located adjacent each other, and have top contacts located in a substantially common plane.

15. A module according to claim 14, wherein said red LED includes at least one active layer of aluminum gallium arsenide (AlGaAs).

16. A module according to claim 15 or 14, wherein said LEDs comprise respective bottom contacts (47), and wherein said bottom contacts are in a substantially common plane different from said common plane of said top contacts.

17. A module according to claim 16 wherein:
said top contacts are the anode contacts (50);
the cathode (47) of each diode is connected to an individual pin: and
said anode top contacts of each diode are connected to a common anode pin (51).

18. A module according to any of claims 14 to 17, wherein said blue LED comprises a silicon carbide substrate and a Group III nitride active layer.

19. A module according to any of claims 14 to 18, wherein said green LED comprises a silicon carbide substrate and a Group III nitride active layer.

20. A module according to claim 18 or 19, wherein said Group III nitride comprises gallium nitride.

21. A module according to any of claims 14 to 18, wherein said green LED comprises a Group III phosphide active layer.

22. A module according to claim 21, wherein said Group III phosphide comprises gallium phosphide.

23. A module according to claim 21, wherein said Group III phosphide comprises aluminum indium gallium phosphide (Al InGaP).

24. A module according to any of claims 14 to 17, wherein:
said blue LED comprises a silicon carbide substrate and a Group III nitride active layer;
said green LED comprises a silicon carbide substrate and a Group III nitride active layer; and
said blue LED and said green LED have their voltage parameters matched to one another to simplify the driving thereof.

25. A module according to any of claims 14 to 24, wherein each pixel can form any color on that portion of a CIE curve that falls within a triangle whose sides are formed by a line on the CIE curve between about 430 nm and 660 nm, a line between about 660 nm and a point between 500 and 530 nm, and a line between said 500-530 nm point and about 430 nm.

26. A module according to claim 1, wherein different color LEDs (20) of the matrix of pixels (21) are commonly connected so that a voltage applied to one LED of the commonly connected LEDs is applied to all of the commonly connected LEDS, and the driving circuitry (34) includes driver means (37) for providing different voltages to the commonly connected different color LEDs in said matrix.

27. A module according to claim 26, wherein said driver means comprises:
means for providing a first voltage (100) to a first selected group of LEDs of said matrix of pixels; and
means for providing a second voltage (102) to a second selected group of LEDs of said matrix.

28. A module according to claim 26 or 27, wherein the LEDs of said matrix of pixels comprises a plurality of rows of LEDs of different colors which are commonly connected such that a voltage is applied to each LED in a row of LEDS and wherein said driver means comprises means for multiplexing the different voltages to the row of LEDs so as to provide different voltages to the LEDs of the row of LEDS.

29. A module according to 26, 27 or 28, further comprising:
multiplexing means (36) operably associated with said means for providing a first voltage and said means for providing a second voltage for sequentially activating said means for providing a first voltage and said means for providing a second voltage such that the first voltage and the second voltage are multiplexed to the commonly connected LEDS.

30. A module according to claim 29, further comprising means for selectively activating LEDS (41) from the first selected group of LEDs when the first voltage is provided to the commonly connected LEDs and for selectively activating LEDs (42/43) from the second selected group of LEDs when the second voltage is provided to the commonly connected LEDS.

31. A module according to claim 1, wherein the light emitting diodes of the matrix are divided into at least one row having at least one diode operating with a first voltage and at least one diode operating with a second voltage, and the driving circuitry comprises:
a first driver (100) connected to said light emitting diodes in said row for applying said first voltage to said light emitting diodes, wherein the first voltage is applied to the light emitting diodes of the row of diodes when said first driver is active;
a second driver (102) connected to said light emitting diodes in said row for applying said second voltage to said light emitting diodes, wherein the second voltage is applied to the light emitting diodes of the row of diodes when said second driver is active;
voltage selection (36) means connected to said first driver and said second driver for selectively activating said first driver to provide said first voltage to said row of diodes and for selectively activating said second driver to provide said second voltage to said row of diodes; and
light emitting diode (41, 42/43) selection means connected to the diodes in said row for selectively activating said diodes when a voltage is applied to said diodes.

32. A module according to claim 31, wherein said light emitting diode selection means further comprises means for selectively activating said diodes operating with a first voltage when said voltage selection means activates said first driver and selectively activating said diodes operating with a second voltage when said voltage selection means activates said second driver.

33. A module according to claim 32, wherein said diodes requiring said first voltage comprise blue light emitting diodes and wherein said diodes requiring said second voltage comprise red and green light emitting diodes.

34. A module according to claim 31, 32 or 33, wherein said light emitting diodes of a row have commonly connected anodes.

35. A module according to any of claims 31 to 34, further comprising multiplexing means for sequentially causing said voltage selection means to provide said first voltage and said second voltage to the diodes in the row.

36. A module according to any of claims 31 to 35, wherein said diode selection means comprises a first shift register (41) corresponding to said first driver and a second shift register corresponding to said second driver, said first shift register having a bit corresponding to each of said diodes in a row operating on said first voltage and a second shift register (42/43) having a bit corresponding to each of said diodes in a row operating at said second voltage and wherein said diodes are activated by sequentially loading a bit pattern corresponding to the selected diodes to said shift registers.

37. A module according to claim 36, wherein said first shift register is enabled when said second shift register is disabled and wherein said second shift register is enabled when said first shift register is disabled.

38. A module according to claim 37, wherein said voltage selection means selects said first voltage when said first shift register is enabled and selects said second voltage when said second shift register is enabled.

39. A module according to claim 37, wherein said light emitting diodes of said matrix comprise a plurality of rows, and wherein each of said rows has a corresponding first driver for providing a first voltage to the row and a corresponding second driver for providing a second voltage to the row.

40. A module according to claim 39, further comprising scanning means for sequentially causing for each row of said plurality of rows said voltage selection means to activate said first driver to provide said first voltage to a row and to activate said second driver to provide said second voltage to said row.

## Patentansprüche

1. Dünner Vollfarben-Flachanzeigemodul (20) mit:
einer Platine (22) mit gedrucktem Schaltkreis,
einer Matrix aus im wesentlichen ebenen Vollfarbenpixeln (21), die an einer ersten Oberfläche der gedruckten Schaltkreisplatine angebracht sind,
wobei jedes Pixel eine lichtemittierende Diode (44) aufweist, die im roten Bereich des sichtbaren Spektrums emittiert, eine lichtemittierende Diode (45) aufweist, die im grünen Bereich des sichtbaren Spektrums emittiert, und eine lichtemittierende Diode (46) aufweist, die im blauen Bereich des sichtbaren Spektrums emittiert, und
einem Treiberschaltkreis (34), für das wahlweise Aktivieren der lichtemittierenden Dioden, die auf der entgegengesetzten Fläche der gedruckten Schaltkreisplatine angeordnet sind.

2. Modul nach Anspruch 1, wobei der Treiberschaltkreis Verbindungen zwischen den Pixeln und dem Treiberschaltkreis aufweist, die durch die Schaltkreisplatine hindurch durch Plattierung hergestellt sind.

3. Modul nach Anspruch 2, wobei der Treiberschaltkreis aufweist:
einen Eingangspuffer (35),
einen Demultiplexer (36), der auf den Eingangspuffer anspricht,
einen Zeilentreiber (37), der auf den Demultiplexer anspricht, und
einen Spaltentreiber (40), der auf den Eingangspuffer anspricht.

4. Modul nach Anspruch 1, wobei jedes der Pixel aufweist:
eine gemeinsame Anode (51) für alle drei LEDs in dem Pixel, um das gesamte Pixel ein- oder auszuschalten, und
eine individuelle Kathode (47) für jede individuelle LED in dem Pixel, um den Zustand und die Helligkeit jedes der LEDs zu steuern bzw. zu regeln, um dadurch die von dem Pixel insgesamt ausgegebene Farbe einzustellen.

5. Modul nach Anspruch 1, welcher weiterhin eine monostabile Schaltkreiseinrichtung für die Erfassung der Ausgabe von einem oder mehreren periodischen Eingangssignalen aufweist, sowie für das Abschalten der Energiezufuhr zu dem Pixel, wenn solche Eingangssignale für eine definierte Zeitdauer fehlen, so daß eine maximale Schaltgeschwindigkeit der Dioden in den Pixeln nicht überschritten wird.

6. Modul nach Anspruch 1, welcher weiterhin eine vordere Maskierungsplatte (23) auf derselben Seite der gedruckten Schaltkreisplatine aufweist wie die Pixel.

7. Modul nach Anspruch 6, wobei die vordere Maskierungsplatte weiterhin Linsen über den Pixeln aufweist sowie Reflektoren (25) und Kontrastverstärkungsmittel (34) neben den Pixeln.

8. Modul nach Anspruch 6, wobei die vordere Maskierungsplatte weiterhin eine leitfähige Beschichtung aufweist, die mit dem Massesignal des Treiberschaltkreises in Kontakt ist, um dadurch die elektromagnetischen Emissionen des Moduls zu reduzieren.

9. Modul nach Anspruch 6, welcher weiterhin einen Halterahmen (26) auf der von dem Pixel aus entgegengesetzten Oberfläche der gedruckten Schaltkreisplatine aufweist.

10. Modul nach Anspruch 9, wobei:
die vordere Maskierungsplatte weiterhin einen Pfosten bzw. Zapfen (27) aufweist,
die gedruckte Schaltkreisplatine ein Freiloch (30) aufweist, welches mit dem Zapfen zusammenpaßt und durch welches sich der Zapfen hindurch erstreckt, und
der Halterahmen eine Einrichtung zur Aufnahme des Zapfens (31) aufweist, in welcher der Zapfen aufgenommen ist, und
mit Einrichtungen für das Befestigen des Rahmens an dem Zapfen, um die vordere Maskierungsplatte mit der gedruckten Schaltkreisplatine dazwischen an dem Rahmen zu befestigen und um dadurch eine Verschiebung der gedruckten Schaltkreisplatine von der Platte oder dem Rahmen minimal zu machen oder zu verhindern, während jedoch ermöglicht wird, daß sich die gedruckte Schaltkreisplatine und der Rahmen im Falle thermischer Ausdehnung unabhängig voneinander bewegen.

11. Modul nach Anspruch 9, wobei der Rahmen einen ersten Schlitz (32) neben der gedruckten Schaltkreisplatine aufweist, um einen Luftstrom zwischen dem Rahmen und der Platine zu ermöglichen, um eine Wärmeverteilung bzw. Ableitung zu unterstützen.

12. Modul nach Anspruch 9, wobei der Rahmen leitfähige Befestigungseinrichtungen gegenüber der gedruckten Schaltkreisplatine aufweist, um den Modul abnehmbar an eine Stromquelle zu klemmen.

13. Modul nach Anspruch 1, welcher jede Farbe auf demjenigen Teil einer CIE-Kurve bilden kann, die in ein Dreieckfeld, dessen Seiten durch eine Linie auf der CIE-Kurve zwischen etwa 430 nm und 660 nm, einer Linie zwischen 660 nm und einem Punkt zwischen 500 und 530 nm, und einer Linie zwischen dem Punkt von 500-530 nm und etwa 430 nm gebildet werden.

14. Modul nach Anspruch 1, wobei die roten, grünen und blauen LEDs (44, 45, 46) jedes Pixels nebeneinander angeordnet sind und auf ihrer Oberseite Kontakte in einer im wesentlichen gemeinsamen Ebene haben.

15. Modul nach Anspruch 14, wobei die rote LED zumindest eine aktive Schicht aus Aluminiumgalliumarsenid (AlGaAs) aufweist.

16. Modul nach Anspruch 14 oder 15, wobei die LEDs jeweils untere Kontakte (47) aufweisen und wobei die Bodenkontakte bzw. unteren Kontakte sich in einer im wesentlichen gemeinsamen Ebene befinden, die sich von der gemeinsamen Ebene der oberen Kontakte unterscheidet.

17. Modul nach Anspruch 16, wobei:
die oberen Kontakte die Anodenkontakte (50) sind,
die Kathode (47) jeder Diode mit einem individuellen Anschluß bzw. Anschlußstift verbunden ist, wobei die oberen Anodenkontakte jeder Diode mit einem gemeinsamen Anodenanschluß bzw. Anschlußstift (51) verbunden sind.

18. Modul nach einem der Ansprüche 14 bis 17, wobei die blaue LED ein Siliciumcarbidsubstrat und eine aktive Schicht aus einem Nitrid der Gruppe III aufweist.

19. Modul nach einem der Ansprüche 14 bis 18, wobei die grüne LED ein Siliciumcarbidsubstrat und eine aktive Schicht aus einem Nitrid der Gruppe III aufweist.

20. Modul nach Anspruch 18 oder 19, wobei das Nitrid der Gruppe III Galliumnitrid aufweist.

21. Modul nach einem der Ansprüche 14 bis 18, wobei die grüne LED eine aktive Schicht aus einem Phosphid der Gruppe III aufweist.

22. Modul nach Anspruch 21, wobei das Phosphid der Gruppe III Galliumphosphid aufweist.

23. Modul nach Anspruch 21, wobei das Phosphid der Gruppe III Aluminiumindiumgalliumphosphid (Al InGaP) aufweist.

24. Modul nach einem der Ansprüche 14 bis 17, wobei:
die blaue LED ein Siliciumcarbidsubstrat und eine aktive Schicht eines Nitrides der Gruppe III aufweist,
die grüne LED ein Siliciumcarbidsubstrat und eine Aktivschicht aus einem Gruppe III-Nitrid aufweist, und
die blaue LED und die grüne LED hinsichtlich ihrer Spannungsparameter einander angepaßt sind, um ihr Treiben zu vereinfachen.

25. Modul nach einem der Ansprüche 14 bis 24, wobei jedes Pixel jede Farbe auf dem Teil einer CIE-Kurve bilden kann, die in ein Dreieck fällt, dessen Seiten von einer Linie auf der CIE-Kurve zwischen etwa 430 nm und 660 nm, einer Linie zwischen etwa 660 nm und einem Punkt zwischen 500 und 530 nm und einer Linie zwischen dem Punkt zwischen 500 bis 530 nm und etwa 430 nm gebildet wird.

26. Modul nach Anspruch 1, wobei LEDs (20) unterschiedlicher Farbe der Matrix aus Pixeln (21) gemeinsam angeschlossen (zusammengeschaltet) sind, so daß eine an einer LED der miteinander verbundenen LEDs angelegte Spannung an all den gemeinsam angeschlossenen LEDs angelegt wird, und der Treiberschaltkreis (34) Treibereinrichtungen (37) beinhaltet für das Bereitstellen unterschiedlicher Spannungen an den gemeinsam angeschlossenen LEDs unterschiedlicher Farbe in der Matrix.

27. Modul nach Anspruch 26, wobei die Treibereinrichtung aufweist:
eine Einrichtung für das Bereitstellen einer ersten Spannung (100) an einer ersten ausgewählten Gruppe von LEDs der Matrix aus Pixeln und
eine Einrichtung für das Bereitstellen einer zweiten Spannung (102) an einer zweiten ausgewählten Gruppe von LEDs der Matrix.

28. Modul nach Anspruch 26 oder 27, wobei die LEDs der Matrix aus Pixeln eine Mehrzahl von Reihen von LEDs unterschiedlicher Farben aufweist, die gemeinsam angeschlossen sind, so daß eine Spannung an jeder LED in einer Reihe von LEDs angelegt wird, und wobei die Treibereinrichtung Einrichtungen für eine Multiplexschaltung der verschiedenen Spannungen an die Reihe von LEDs aufweist, um unterschiedliche Spannungen an den LEDs der Reihe aus LEDs bereitzustellen.

29. Modul nach Anspruch 26, 27 oder 28, welcher weiterhin aufweist:
eine Multiplexeinrichtung (36), die wirksam mit der Einrichtung für das Bereitstellen einer ersten Spannung und der Einrichtung für das Bereitstellen einer zweiten Spannung verbunden ist, um nacheinander die Einrichtung für das Bereitstellen einer ersten Spannung und der Einrichtung für das Bereitstellen einer zweiten Spannung zu aktivieren, so daß die erste Spannung und die zweite Spannung im Multiplexbetrieb an die gemeinsam angeschlossenen LEDs angelegt werden.

30. Modul nach Anspruch 29, welcher weiterhin eine Einrichtung für das gezielte Aktivieren von LEDs (41) aus der ersten ausgewählten Gruppe von LEDs aufweist, wenn die erste Spannung für die gemeinsam angeschlossenen LEDs bereitgestellt wird, und um gezielt bzw. wahlweise LEDs (42/43) aus der zweiten ausgewählten Gruppe von LEDs zu aktivieren, wenn die zweite Spannung für die gemeinsam angeschlossenen LEDs bereitgestellt wird.

31. Modul nach Anspruch 1, wobei die lichtemittierenden Dioden der Matrix in zumindest eine Reihe, welche zumindest eine mit einer ersten Spannung arbeitende Diode, und in zumindest eine mit einer zweiten Spannung arbeitende Diode aufgeteilt sind, und wobei der Treiberschaltkreis aufweist:
einen ersten Treiber (100), der mit den lichtemittierenden Dioden in der Reihe verbunden ist, um die erste Spannung an die lichtemittierenden Dioden anzulegen, wobei die erste Spannung an die lichtemittierenden Dioden der Reihe von Dioden angelegt wird, wenn der erste Treiber aktiv ist,
einen zweiten Treiber (102), der mit den lichtemittierenden Dioden in der Reihe angelegt ist, um die zweite Spannung an die lichtemittierenden Dioden anzulegen, wobei die zweite Spannung an die lichtemittierenden Dioden der Reihe von Dioden angelegt wird, wenn der zweite Treiber aktiv ist,
eine Spannungsauswahleinrichtung (36), die mit dem ersten Treiber und dem zweiten Treiber verbunden ist, um wahlweise den ersten Treiber zu aktivieren, um die erste Spannung für die Reihe von Dioden bereitzustellen und um wahlweise den zweiten Treiber zu aktivieren, um die zweite Spannung für die Reihe von Dioden bereitzustellen, und
eine Auswahleinrichtung für die lichtemittierenden Dioden (41, 42/43), welche mit den Dioden in der Reihe verbunden ist, um wahlweise die betreffenden Dioden auszuwählen, wenn eine Spannung an den Dioden angelegt wird.

32. Modul nach Anspruch 31, wobei die Auswahleinrichtung für die lichtemittierende Dioden weiterhin eine Einrichtung aufweist, um wahlweise die Dioden zu aktivieren, welche mit einer ersten Spannung arbeiten, wenn die Spannungsauswahleinrichtung den ersten Treiber aktiviert, und um wahlweise die Dioden zu aktivieren, welche mit einer zweiten Spannung arbeiten, wenn die Spannungsauswahleinrichtung den zweiten Treiber aktiviert.

33. Modul nach Anspruch 32, wobei die Dioden, welche die erste Spannung erfordern, blaues Licht emittierende Dioden aufweisen und wobei die Dioden, welche die zweite Spannung erfordern, rotes und grünes Licht emittierende Dioden aufweisen.

34. Modul nach Anspruch 31, 32 oder 33, wobei die lichtemittierenden Dioden eine Reihe gemeinsam angeschlossene (zusammengeschaltete) Anoden haben.

35. Modul nach einem der Ansprüche 31 bis 34, welche weiterhin eine Multiplexeinrichtung aufweisen, um der Reihe nach zu bewirken, daß die Spannungsauswahleinrichtung die erste Spannung und die zweite Spannung für die Dioden in der Reihe bereitstellt.

36. Modul nach einem der Ansprüche 31 bis 35, wobei die Diodenauswahleinrichtung ein erstes Schieberegister (41) aufweist, welches dem ersten Treiber entspricht, und ein zweites Schieberegister aufweist, welches dem zweiten Treiber entspricht, wobei das erste Schieberegister ein Bit hat, welches jeder der Dioden in einer Reihe entspricht, welche mit der ersten Spannung betrieben werden, und ein zweites Schieberegister (42/43) aufweist, welches ein Bit hat, das jeder der Dioden in einer Reihe entspricht, die mit der zweiten Spannung betrieben werden, und wobei die Dioden aktiviert werden, indem nacheinander ein Bitmuster geladen wird, welches den ausgewählten Dioden der Schieberegister entspricht.

37. Modul nach Anspruch 36, wobei das erste Schieberegister freigegeben bzw. in Betrieb gesetzt wird, wenn das zweite Schieberegister ausgeschaltet ist und wobei das zweite Schieberegister freigegeben bzw. eingeschaltet wird, wenn das erste Schieberegister ausgeschaltet ist.

38. Modul nach Anspruch 37, wobei die Spannungsauswahleinrichtung die erste Spannung auswählt, wenn das erste Schieberegister eingeschaltet ist, und die zweite Spannung auswählt, wenn das zweite Schieberegister eingeschaltet ist.

39. Modul nach Anspruch 37, wobei die lichtemittierenden Dioden der Matrix eine Mehrzahl von Reihen aufweisen und wobei jede der Reihen einen entsprechenden ersten Treiber für die Bereitstellung einer ersten Spannung für die Reihe und einen entsprechenden zweiten Treiber für die Bereitstellung einer zweiten Spannung für die Reihe hat.

40. Modul nach Anspruch 39, welcher weiterhin eine Abtasteinrichtung hat, um nacheinander zu bewirken, daß jede Reihe aus der Mehrzahl von Reihen der Spannungsauswahleinrichtung den ersten Treiber aktiviert, um die erste Spannung für eine Reihe bereitzustellen und der zweite Treiber aktiviert wird, um die zweite Spannung für die Reihe bereitzustellen.

## Revendications

1. Module de panneau plat et fin d'affichage de couleurs pures (20) comprenant :
- une plaque de circuit imprimé (22) ;
- une matrice de pixels de couleurs pures sensiblement plate (21) montée sur une première surface de ladite plaque de circuits imprimés ;
- chacun des dits pixels comprenant une diode électroluminescente (44) qui émet dans la partie rouge du spectre visible, une diode électroluminescente (45) qui émet dans la partie verte du spectre visible et une diode électroluminescente (46) qui émet dans la partie bleue du spectre visible ; et
- une circuiterie de commande (34) pour sélectivement activer lesdites diodes électroluminescentes montées sur la surface opposée de ladite plaque de circuit imprimé.

2. Module selon la revendication 1, dans lequel ladite circuiterie de commande comprend des interconnexions entre lesdits pixels et ladite circuiterie de commande plaquée à travers ladite plaque de circuit imprimé.

3. Module selon la revendication 2, dans lequel ladite circuiterie de commande comprend :
- un tampon d'entrée (35) ;
- un démultiplexeur (36) sensible audit tampon d'entrée ;
- un excitateur de rangée (37) sensible audit multiplexeur ; et
- un excitateur de colonne (40) sensible audit tampon d'entrée.

4. Module selon la revendication 1, dans lequel chacun desdits pixels comprend :
- une anode commune (51) pour les trois LEDs dans ledit pixel pour allumer ou éteindre le pixel entier ; et
- une cathode individuelle (47) pour chaque LED individuelle dans ledit pixel pour commander l'état et la brillance de chacune desdites LEDs pour ainsi commander la couleur globale émise par ledit pixel.

5. Module selon la revendication 1, comprenant en outre des moyens de circuit monostables pour détecter l'apparition de un ou plusieurs signaux d'entrée périodiques, et pour couper l'alimentation vers le pixel lorsque de tels signaux d'entrée sont absents pour une période définie de temps de sorte qu'une puissance maximale desdites diodes dans lesdits pixels n'est pas excédée.

6. Module selon la revendication 1, comprenant en outre une plaque de masquage frontale (23) sur la même surface de ladite plaque de circuits imprimés que lesdits pixels.

7. Module selon la revendication 6, dans lequel ladite plaque de masquage frontale comprend en outre des lentilles au-dessus desdits pixels, et des réflecteurs (25) et des moyens d'augmentation de contraste (24) adjacents auxdits pixels.

8. Module selon la revendication 6, dans lequel ladite plaque de masquage frontale comprend en outre un revêtement conducteur qui est en contact avec le signal de masse de ladite circuiterie de commande pour ainsi réduire les émissions électromagnétiques dudit module.

9. Module selon la revendication 6, comprenant en outre une structure de support (26) sur ladite surface opposée de ladite plaque de circuits imprimés par rapport auxdits pixels.

10. Module selon la revendication 9, dans lequel :
- ladite plaque de masquage frontale comprend en outre une tige (27) ;
- ladite plaque de circuits imprimés comprend un trou (30) qui s'adapte avec ladite tige et à travers lequel ladite tige s'étend ; et
- ladite structure de support comprend des moyens (31) pour recevoir ladite tige et dans laquelle ladite tige est reçue ; et
- des moyens pour fixer ladite structure à ladite tige pour fixer ladite plaque de masquage frontale à ladite structure avec ladite plaque de circuits imprimés entre elles et pour ainsi minimiser ou empêcher ladite plaque de circuits imprimés de se disloquer par rapport à ladite plaque ou ladite structure, mais tout en permettant à ladite plaque de circuits imprimés et à ladite structure de se déplacer indépendamment en cas d'une dilatation thermique.

11. Module selon la revendication 9, dans lequel ladite structure comprend une première fente (32) adjacente à ladite plaque de circuits imprimés pour permettre l'écoulement d'air entre ladite structure et ladite plaque pour aider dans la dissipation de chaleur.

12. Module selon la revendication 9, dans lequel ladite structure comprend des moyens de montage conducteurs opposés à ladite plaque de circuits imprimés pour relier de manière amovible ledit module à une source d'alimentation.

13. Module selon la revendication 1, qui peut former une couleur quelconque sur la partie d'une courbe CIE qui tombe dans un triangle dont les côtés sont formés par une ligne sur la courbe CIE située entre environ 430 nm et 660 nm, une ligne située entre 660 nm et un point situé entre 500 et 530 nm, et une ligne situé entre ledit point de 500-530 nm et environ 430 nm.

14. Module selon la revendication 1, dans lequel lesdites LEDs rouge, verte et bleue (44, 45, 46) de chaque pixel sont situées adjacentes l'une à l'autre, et ont des contacts supérieurs situés dans un plan sensiblement commun.

15. Module selon la revendication 14, dans lequel ladite LED rouge comprend au moins une couche active d'arsénure de gallium d'aluminium (AlGaAs).

16. Module selon la revendication 5 ou 14, dans lequel lesdites LEDs comprennent des contacts de fond respectifs (47), et dans lequel lesdits contacts de fond sont dans un plan sensiblement commun différent dudit plan commun desdits contacts supérieurs.

17. Module selon la revendication 16, dans lequel :
- lesdits contacts supérieurs sont les contacts d'anode (50) ;
- la cathode (47) de chaque diode est connectée à un broche individuelle ; et
- lesdits contacts supérieurs d'anode de chaque diode sont connectés à une broche d'anode commune (51).

18. Module selon l'une quelconque des revendications 14 à 17, dans lequel ladite LED bleue comprend un substrat en carbure de silicium et une couche active en nitrure du groupe III.

19. Module selon l'une quelconque des revendications 14 à 18, dans lequel ladite LED verte comprend un substrat en carbure de silicium et une couche active en nitrure du groupe III.

20. Module selon la revendication 18 ou 19, dans lequel ledit nitrure du groupe III comprend du nitrure de gallium.

21. Module selon l'une quelconque des revendications 14 à 18, dans lequel ladite LED verte comprend une couche active en phosphure du groupe III.

22. Module selon la revendication 21, dans lequel ledit phosphure du groupe III comprend du phosphure de gallium.

23. Module selon la revendication 21, dans lequel ledit phospuhre du groupe III comprend du phosphure de gallium indium aluminium (AlInGaP).

24. Module selon l'une quelconque des revendications 14 à 17, dans lequel :
- ladite LED bleue comprend un substrat en carbure de silicium et une couche active en nitrure du groupe III ;
- ladite LED verte comprend un substrat en carbure de silicium et une couche active en nitrure du groupe III ; et
- ladite LED bleue et ladite LED verte ont leur paramètre de tension adaptés l'une à l'autre pour simplifier leur commande.

25. Module selon l'une quelconque des revendications 14 à 24, dans lequel chaque pixel peut former une couleur quelconque sur la partie d'une courbe CIE qui tombe dans un triangle dont les côtés sont formés par une ligne sur la courbe CIE située entre environ 430 nm et 660 nm, une ligne située entre environ 660 nm et un point situé entre 500 et 530 nm, et une ligne située entre ledit point entre 500 et 530 nm et environ 430 nm.

26. Module selon la revendication 1, dans lequel des LEDs de différentes couleurs (20) de la matrice de pixel (21) sont connectées de manière commune de telle sorte qu'une tension appliquée à une LED parmi les LEDs connectées de manière commune est appliquée à toutes les LEDs connectées de manière commune, et la circuiterie de commande (34) comprend des moyens d'entraînement (37) pour fournir des tensions différentes aux LEDs de couleurs différentes connectées de manière commune dans ladite matrice.

27. Module selon la revendication 26, dans lequel lesdits moyens d'entraînement comprennent :
- des moyens pour fournir une première tension (100) à un premier groupe sélectionné de LEDs dans ladite matrice de pixels ; et
- des moyens pour fournir une seconde tension (102) à un second groupe sélectionné de LEDs de ladite matrice.

28. Module selon la revendication 26 ou 27, dans lequel les LEDs de ladite matrice de pixels comprennent une pluralité de rangées de LEDs de différentes couleurs qui sont connectées de manière commune de telle sorte qu'une tension est appliquée à chaque LED dans une rangée de LEDs, et dans lequel lesdits moyens d'entraînement comprennent des moyens pour multiplexer des différentes tensions à la rangée de LEDs de manière à fournir différentes tensions aux LEDs de la rangée de LEDs.

29. Module selon la revendication 26, 27 ou 28, comprenant en outre :
- des moyens de multiplexage (36) associés de manière opérante avec lesdits moyens pour fournir une première tension et lesdits moyens pour fournir une seconde tension pour séquentiellement activer lesdits moyens pour fournir une première tension et lesdits moyens pour fournir une seconde tension de telle sorte que la première tension et la seconde tension sont multiplexées aux LEDs connectées de manière commune.

30. Module selon la revendication 29, comprenant en outre des moyens pour sélectivement activer des LEDs (41) à partir du premier groupe de LEDs sélectionné lorsque la première tension est fournie aux LEDs connectées de manière commune et pour sélectivement activer des LEDs (42/43) du second groupe de LEDs sélectionné lorsque la seconde tension est fournie aux LEDs connectées de manière commune.

31. Module selon la revendication 1, dans lequel les diodes électroluminescentes de la matrice sont divisées en au moins une rangée ayant au moins une diode fonctionnant avec une première tension et au moins une diode fonctionnant avec une seconde tension, et la circuiterie de commande comprend :
- un premier excitateur (100) connecté auxdites diodes électroluminescentes dans ladite rangée pour appliquer ladite première tension auxdites diodes électroluminescentes, dans lequel la première tension est appliquée aux diodes électroluminescentes de la rangée de diodes lorsque ledit premier excitateur est actif ;
- un second excitateur (102) connecté auxdites diodes électroluminescentes dans ladite rangée pour appliquer ladite seconde tension auxdites diodes électroluminescentes, lorsque la seconde tension est appliquée aux diodes électroluminescentes de la rangée de diodes lorsque ledit second excitateur est actif ;
- des moyens de sélection de tension (36) connectés audit premier excitateur et audit second excitateur pour sélectivement activer ledit premier excitateur pour fournir ladite première tension à ladite rangée de diodes et pour sélectivement activer ledit second excitateur pour fournir ladite second tension à ladite rangée de diodes ; et
- des moyens de sélection de diodes électroluminescentes (41, 42/43) connectés aux diodes dans ladite rangée pour sélectivement activer lesdites diodes lorsqu'une tension est appliquée auxdites diodes.

32. Module selon la revendication 31, dans lequel lesdits moyens de sélection de diodes électroluminescentes comprennent en outre des moyens pour sélectivement activer lesdites diodes fonctionnant avec une première tension lorsque lesdits moyens de sélection de tension activent ledit premier excitateur et sélectivement activer lesdites diodes fonctionnant avec une seconde tension lorsque lesdits moyens de sélection de tension activent ledit second excitateur.

33. Module selon la revendication 32, dans lequel lesdites diodes nécessitant ladite première tension comprennent des diodes électroluminescentes bleues et dans lequel lesdites diodes nécessitant ladite seconde tension comprennent des diodes électroluminescentes rouges et vertes.

34. Module selon la revendication 31, 32 ou 33, dans lequel lesdites diodes électroluminescentes d'une rangée ont des anodes connectées de manière commune.

35. Module selon l'une quelconque des revendications 31 à 34, comprenant en outre des moyens de multiplexage pour séquentiellement amener lesdits moyens de sélection de tension à fournir ladite première tension et ladite seconde tension aux diodes dans la rangée.

36. Module selon l'une quelconque des revendications 31 à 35, dans lequel lesdits moyens de sélection de diodes comprennent un premier registre à décalage (41) correspondant audit premier excitateur et un second registre à décalage correspondant audit second excitateur, ledit premier registre à décalage ayant un bit correspondant à chacune desdites diodes dans la rangée fonctionnant sur ladite première tension et un second registre à décalage (42/43) ayant un bit correspondant à chacune desdites diodes dans une rangée fonctionnant à la seconde tension, et dans lequel lesdites diodes sont activées en chargeant séquentiellement un motif de bit correspondant aux diodes sélectionnées audit registre de décalage.

37. Module selon la revendication 36, dans lequel ledit premier registre à décalage est activé lorsque ledit second registre à décalage est désactivé et dans lequel ledit second registre à décalage est activé lorsque ledit premier registre à décalage est désactivé.

38. Module selon la revendication 37, dans lequel lesdits moyens de sélection de tension sélectionnent ladite première tension lorsque ledit premier registre à décalage est activé et sélectionne ladite seconde tension lorsque ledit second registre à décalage est activé.

39. Module selon la revendication 37, dans lequel lesdites diodes électroluminescentes de ladite matrice comprennent une pluralité de rangées, et dans lequel chacune desdites rangées a un premier excitateur correspondant pour fournir une première tension à la rangée et un second excitateur correspondant pour fournir une seconde tension à la rangée.

40. Module selon la revendication 39, comprenant en outre des moyens de balayage pour séquentiellement amener à chaque rangée de ladite pluralité de rangée lesdits moyens de sélection de tension pour activer ledit premier excitateur pour fournir ladite première tension à une rangée et pour activer ledit second excitateur pour fournir ladite seconde tension à ladite rangée.
